# EUROPEAN PATENT APPLICATION

(11) **EP 1 416 494 A2**
(43) Date of publication of application: **06.05.2004**
(21) Application number: 03003150.4
(22) Date of filing: 18.02.2003
(51) Int. Cl.: G11C 7/22, G11C 8/06, G11C 11/4076, G11C 11/408

(54) **Semiconductor memory capable of performing high-speed processing**

(30) Priority: 31.10.2002 JP 2002318734; 29.01.2003 JP 2003020391
(71) Applicant: Kabushiki Kaisha Toshiba, Tokyo 105-8001 (JP)
(72) Inventor: Kato, Koji Intellectual Property Division, Minato-ku Tokyo 105-8001 (JP); Ohshima, Shigeo Intellectual Property Division, Minato-ku Tokyo 105-8001 (JP)
(74) Representative: HOFFMANN - EITLE

(57) **Abstract**

A semiconductor memory has a memory cell array (11), a command decoder (14), and an input/output control circuit (20). The memory cell array (11) has a plurality of memory cells which store data. The command decoder (14) decodes a command input from outside. The input/output control circuit (20) controls writing of data into the memory cell and an output of the data to the outside, in accordance with an output of the command decoder (14). If a write command is input in the command decoder (14), write data received from outside is written in the memory cell when two write commands are input in the command decoder (14) subsequent to the write command.

## Description

The present invention relates to a semiconductor memory, more particularly, it relates to a semiconductor memory that can operate at high speed, such as a fast cycle random access memory for use in networks.

In recent years, attention has been focused on a fast cycle random access memory, as a semiconductor memory expected to be applied to the field of networks. One of the major features of the fast cycle random access memory is that the time period for allowing consecutive access (random cycle time) for the same bank (memory cell array of a minimum unit and its control circuit) is short. "Random cycle time" means the minimum time interval from start of one read/write to start of next read/write, for the same bank. The bank is a group of memory cells, which cannot be accessed at the same time.

In the fast cycle random access memory, two commands received in successive cycles are decoded, and a write command or read command is generated. It is assumed that the write command is represented by WRA+LAL and the read command is represented by RDA+LAL.

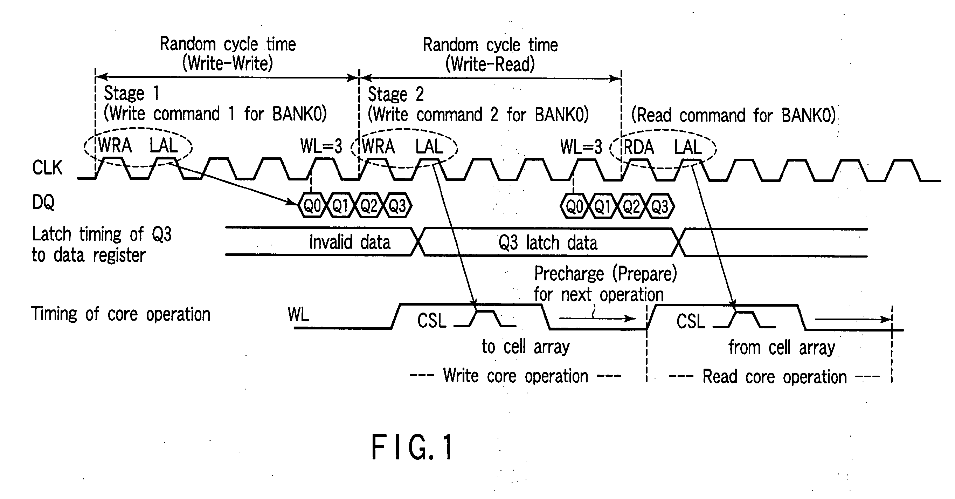

With respect to the write method of the fast cycle random access memory, the following write method has been proposed by the applicant (Jpn. Pat. Appln. KOKAI Publication No. 2001-176267). In this method, as shown in FIG. 1, writing into a memory cell array (bank 0) is not performed during a period of a first write command, write command 1 (stage 1), and write data is temporarily latched by a data register provided outside the memory cell array. Writing from the data register into the memory cell array is actually performed upon the next (second) write command, write command 2, for the same bank.

FIG. 1 shows an example wherein the random cycle time is 5 clock cycles, the write latency is 3 clock cycles, and the burst length is 4 bits (Q0, Q1, Q2 and Q3). "Write latency" means the time from input of a write command LAL to reception of write data Q0. "Burst length" means the length of the data string for each pin which can be dealt with in one access.

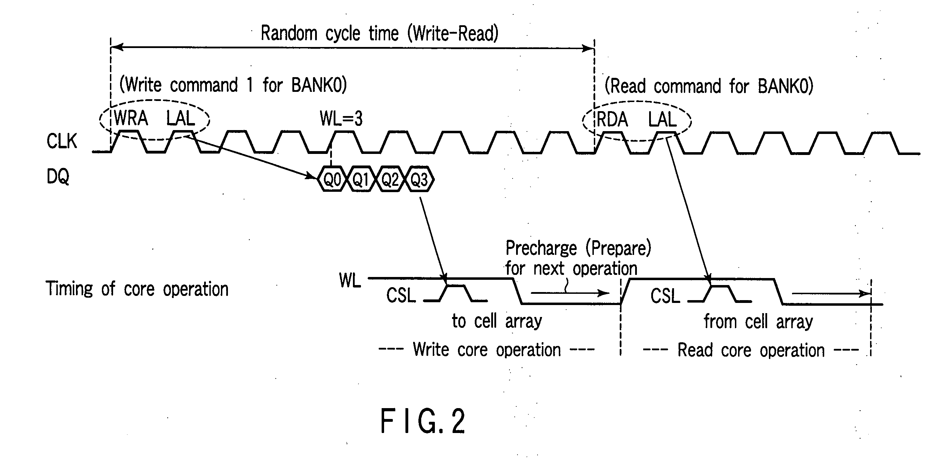

If write data is written in the memory cell array during a period of write command 1 in which the write data is received, without using the above write method, it takes a long time to complete the core operation of actually writing the write data in the memory cell array, as shown in FIG. 2. In particular, the time from when the write command is input and until writing in the memory cell array (core operation) is performed is considerably long, compared with the time from when the read command is input and until reading from the memory cell array (core operation) is performed. Thus, the random cycle time is prolonged in the case of successively executing a write command and read command for the same bank.

On the other hand, in the late write method wherein pipelining is performed between stage 1 for receiving write data and latching the write data in the data register, and stage 2 for writing the write data from the data register to the memory cell array, writing into the memory cell array (core operation) can immediately be performed upon input of a write command. Thus, the random cycle time can easily be reduced.

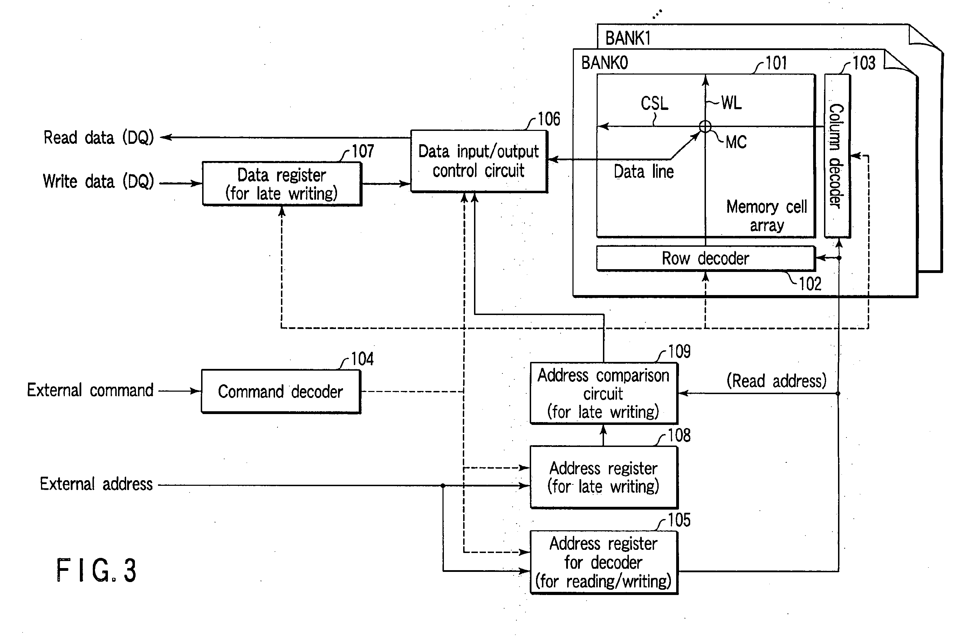

FIG. 3 shows a block structure of a semiconductor memory having the above-described late write method.

As shown in FIG. 3, the semiconductor memory comprises a row decoder 102 and a column decoder 103, as an address selection circuit of a memory cell array 101. The row decoder 102 selects a word line WL. The column decoder 103 selects a column selection line CSL. The semiconductor memory further comprises a command decoder 104, an address register 105 for a decoder, a data input/output control circuit 106, a data register 107 for late writing, an address register 108 and an address comparison circuit 109. The command decoder 104 decodes external commands. The address register 105 stores addresses designating storage locations. The data input/output control circuit 106 controls input/output of data.

In the late write method, when the second write command for the same bank is input, the write data is written in the memory cell array 102. Thus, the data register 107 for temporarily storing the write data during the time until the write data is written in the memory cell array 102, and the address register 108 for storing an address of a memory cell in which the write data is to be written, are indispensable.

Further, if the read command is input in the command decoder 104, and an address the same as the address of a memory cell in which the data temporarily stored in the data register 107 is to be stored, is input in the address register 105, it is necessary to directly read the read data from the data register 107. Thus, the semiconductor memory comprises the address comparison circuit 109 for comparing the address received by the read command, with the address of a memory cell in which the data in the data register 107 is to be stored.

In the conventional fast cycle random access memory, a maximum burst length of 4 bits is mainstream. In recent years, demands for fast cycle random access memory which can input/output data of burst lengths as long as 8 bits or 16 bits have increased. There is, however, a problem in implementing them.

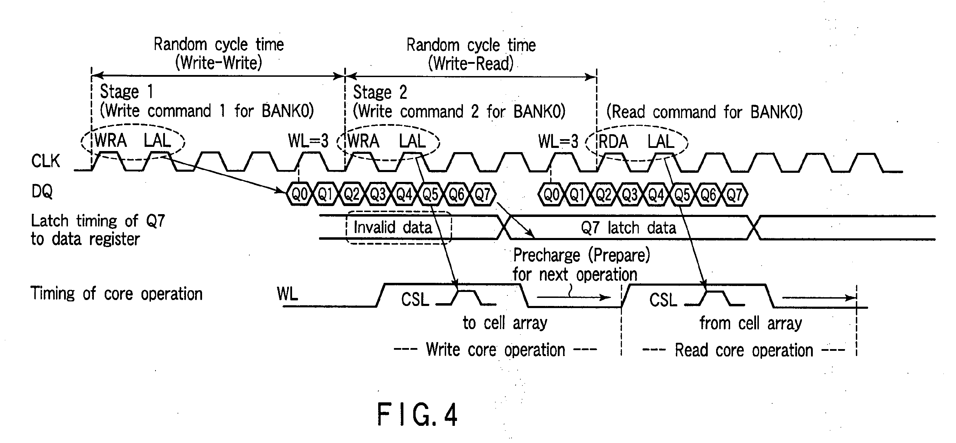

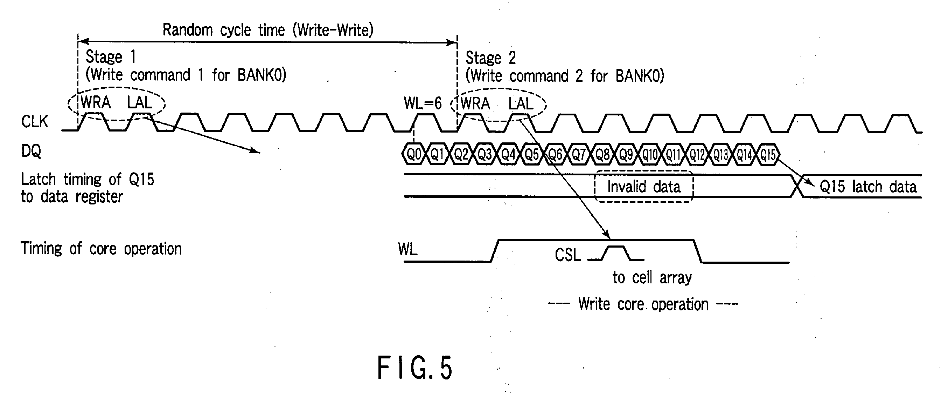

Let us consider a fast cycle random access memory which can input/output data having a burst length as long as 8 bits or 16 bits. In this fast cycle random access memory, the random cycle time is short and the burst length is long. Thus, as shown in FIG. 4 and FIG. 5, the write command 1 is input (stage 1), and the following write command 2 is input (stage 2) to initiate writing into the memory cell array 101 (core operation), before the write data is completely received in the data register 107.

In such a case, since the data register 107 does not completely receive the write data input from outside, invalid data is stored in the data register 107. The invalid data must not be written in the memory cell array 101. That is, it can be said that such a state indicates a failure of the write system.

If the specification is changed such that the write command 2 is allowed after receiving all the write data input with the write command 1, i.e., the random cycle time is made longer, the above problem can be solved. However, this vitiates the main feature of the fast cycle random access memory.

An object of the present invention, which has been achieved in view of the situation described above, is to provide a semiconductor memory which can input/output data having a long burst length, while maintaining a short random cycle time.

According to one aspect of the present invention, there is provided a semiconductor memory comprising:
a memory cell array having a plurality of memory cells which store data; a command decoder which decodes a command input from outside; and an input/output control circuit which controls writing of data into the memory cell and an output of the data to the outside, in accordance with an output of the command decoder.
If a write command is input in the command decoder, write data received from outside is written in the memory cell when two write commands are input in the command decoder subsequent to the input of the write command.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a timing chart showing an example of a first operation of a conventional fast cycle random access memory;
FIG. 2 is a timing chart showing an example of a second operation of the conventional fast cycle random access memory;
FIG. 3 is a block diagram showing a structure of the conventional fast cycle random access memory;
FIG. 4 is a timing chart showing an example of a first defective operation of the conventional fast cycle random access memory;
FIG. 5 is a timing chart showing an example of a second defective operation of the conventional fast cycle random access memory;
FIG. 6 is a block diagram showing a structure of a fast cycle random access memory according to a first embodiment of the present invention;
FIG. 7 is a timing chart showing an operation of the fast cycle random access memory according to the first embodiment of the present invention; and
FIG. 8 is a timing chart showing an operation of a fast cycle random access memory according to a second embodiment of the present invention.

A semiconductor memory according to an embodiment of the present invention will be described with reference to the drawings. A fast cycle random access memory is taken as an example of the semiconductor memory. In the drawings, like reference numerals denote like elements.

### First Embodiment

A fast cycle random access memory according to a first embodiment of the present invention will be described.

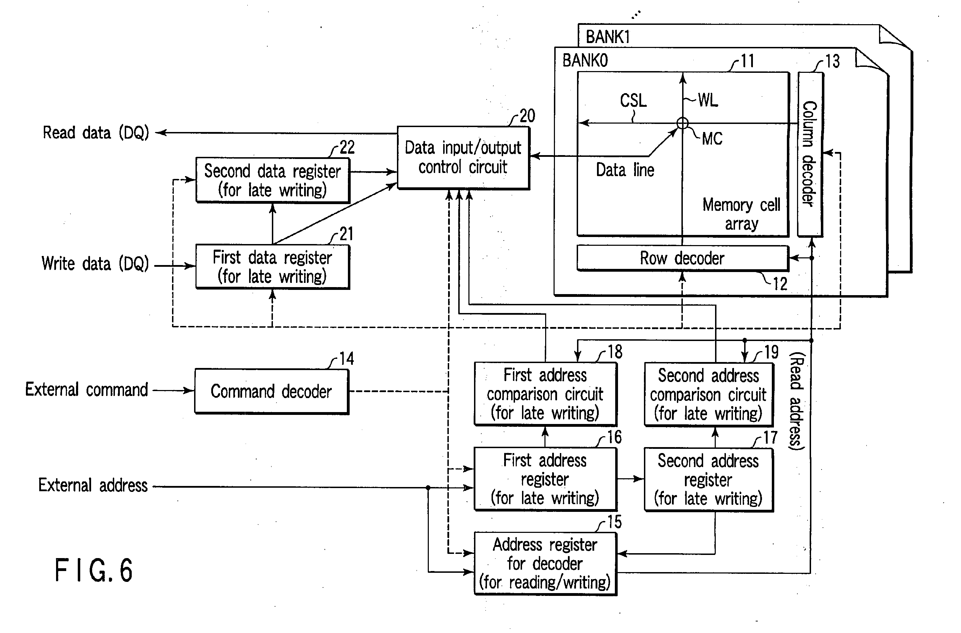

FIG. 6 is a block diagram showing a structure of the fast cycle random access memory according to the first embodiment of the present invention.

As shown in FIG. 6, the fast cycle random access memory comprises a memory cell array 11, a row decoder 12, a column decoder 13, a command decoder 14, an address register 15 for a decoder, a first address register 16, a second address register 17, a first address comparison circuit 18, a second address comparison circuit 19, a data input/output control circuit 20, a first data register 21 and a second data register 22.

The memory cell array 11 comprises a plurality of memory cells MC which store data. In order to select the memory cell MC in the memory cell array 11, the row decoder 12 and the column decoder 13 as an address selection circuit are disposed. The row decoder 12 selects a word line WL based on address data, and the column decoder 13 selects a column selection line CSL. Thereby, the memory cell at the intersection of the word line WL and the column selection line CSL is selected. The command decoder 14 decodes external commands input from outside, for example, commands such as a write command and read command.

The address register 15 for a decoder, the first address register 16, and the second address register 17 store external addresses input from outside, in accordance with the input of external commands. That is, these address registers store addresses of memory cells MC on which writing or reading is performed. The first data register 21 temporarily stores write data (DQ) to be written in the memory cell. The first address register 16 stores an address of a memory cell in which write data stored in the first data register 21 is to be written.

The second data register 22 temporarily stores write data stored in the first data register 21. The second address register 17 stores an address of a memory cell in which write data stored in the second data register is to be written.

The first address comparison circuit 18 compares, when a read command is input, an address stored in the first address register with an address stored in the address register 15, and outputs a comparison result to the data input/output control circuit 20. The second address comparison circuit 19 compares, when a read command is input, an address stored in the second address register with an address stored in the address register 15, and outputs a comparison result to the data input/output control circuit 20.

The data input/output control circuit 20 controls input/output of write data or read data, in accordance with the output from the command decoder 14 and the comparison results from the first and second comparison circuits. That is, the data input/output control circuit 20 controls writing of write data into the memory cell MC, and output of read data to the outside.

Next, an operation of the fast cycle random access memory according to the first embodiment will be explained.

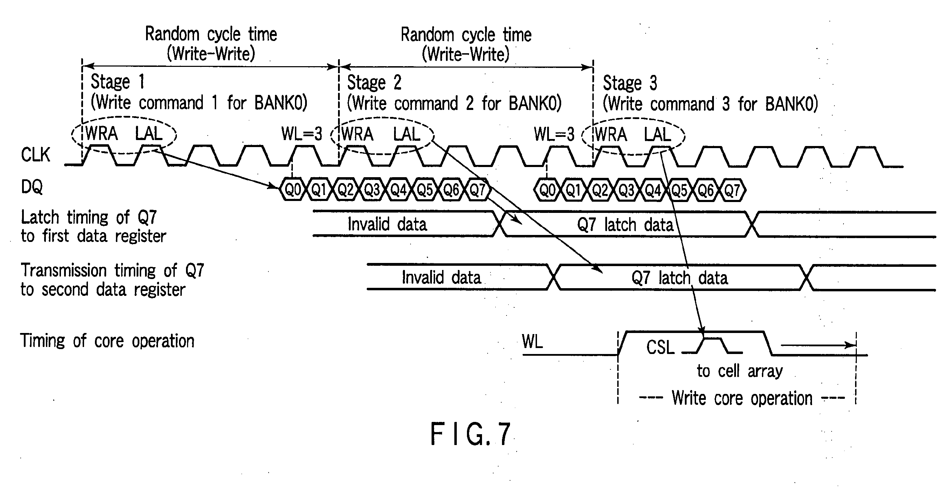

FIG. 7 is a timing chart showing an operation of the fast cycle random access memory according to the first embodiment of the present invention.

FIG. 7 shows an example wherein the random cycle time is 5 clock cycles (5 cycles of a clock CLK), the write latency (WL) is 3 clock cycles, and the burst length of write data (DQ) is 8 bits (Q0, Q1, Q2, ..., Q7).

A write command is provided, being expressed with WRA+LAL, in successive two clock cycles. "Random cycle time" is the shortest time between the start of a read/write operation and the start of the next read/write operation, in the same memory cell array. In this embodiment, it means the minimum time period from input of a write command WRA to input of next write command WRA, for the same bank 0. "Write latency" means the time from input of a write command LAL to reception of write data Q0 by the first data register. "Burst length" means the length of the data string for each pin which can be dealt with in one access. "Write data" means data which is input from outside and written in the memory cell MC within the memory cell array 11 of bank 0.

As shown in FIG. 7, if the first write command, write command 1, is input in the command decoder 14 (stage 1) in order to write write data Q0, Q1, Q2, ..., Q7 into the memory cell array 11 of bank 0, the following operation will be performed. First, write data (DQ) received from outside is stored in the first data register 21. At the same time, an external address input from outside is stored in the first address register 16, as an address of the memory cell into which the write data stored in the first data register 21 is to be written.

Next, if the second write command, write command 2, is input in the command decoder 14 (stage 2) in order to write data in the memory cell array 11 of bank 0, the following operation is performed. The write data stored in the first data register 21 is moved to the second data register 22. Then, write data (DQ) received from outside is stored in the first data register 21. At the same time, the address stored in the first address register 16 is moved to the second address register 17. The external address input from outside is stored in the first address register 16, as an address of the memory cell into which the write data stored in the first data register 21 is to be written.

Further, if the third write command, third write command 3, is input in the command decoder 14 (stage 3) in order to write data in the memory cell array 11 of bank 0, the following operation is performed. The address stored in the second address register 17 is sent via the address register 15 for a decoder to the row decoder 12 and the column decoder 13. Then, the word line WL and the column selection line CSL are selected by the row decoder 12 and the column decoder 13 to determine the memory cell MC in which the write data is to be written. The write data stored in the second data register 22 is moved via the data input/output control circuit 20 to the determined memory cell MC, and is stored.

In such a manner, the write data having a burst length of 8 bits is written in the memory cell MC in the memory cell array 11 (core operation) without changing the random cycle time.

In the above structure, the following improvements are needed with respect to register reading, for directly reading write data from the first and second data registers 21 and 22. If a read command which corresponds to the address of the memory cell in which the data in the first data register 21 or the data in the second data register 22 is to be stored is received, the data must be directly read from the first and second data registers 21 and 22, respectively. Therefore, the first and second address comparison circuits 18 and 19 are provided for determining whether the address respectively stored in the first and second address registers 16 and 17 corresponds to the address read by the read command.

The first address comparison circuit 18 compares the address stored in the first address register 16 with the address input from outside, and determines whether or not they correspond to each other. If they correspond, the first address comparison circuit 18 outputs a signal indicating this, to the data input/output control circuit 20. The data input/output control circuit 20 outputs the data stored in the first data register 21 to the outside as read data.

Similarly, the second address comparison circuit 22 compares the address stored in the second address register 17 with the address input from outside, and determines whether or not they correspond to each other. If they correspond, the second address comparison circuit 19 outputs a signal indicating this, to the data input/output control circuit 20. The data input/output control circuit 20 outputs the data stored in the second data register 22 to the outside as read data.

In the writing operation in the fast cycle RAM according to the first embodiment of the present invention, if the write command 1 is received, write data Q0 to Q7 is temporarily latched in the first data register 21. After that, if the write command 2 is received, the write data Q0 to Q7 temporarily latched in the first data register 21 is moved to the second data register 22, and write data Q0 to Q7 input from outside is temporarily latched in the first data register 21. Further, if the write command 3 is received, the write data Q0 to Q7 temporarily latched in the second data register 22 is stored in the memory cell MC, the write data Q0 to Q7 temporarily latched in the first data register 21 is moved to the second data register 22, and write data Q0 to Q7 input from outside is temporarily latched in the first data register 21.

As described above, the writing operation is divided into three stages, and moving of write data between the first and second data registers 21 and 22 and the memory cell array 11 is pipelined. The write data input by the write command 1 is then written in the cell array 11 upon input of the write command 3 subsequent to input of the two commands.

If a read command is received, it is determined whether the address of the memory cell to be read corresponds to the address corresponding to the data stored in the first data register 21 or the second data register 22. If they correspond, the data stored in the first data register 21 or the second data register 22 is read as read data.

With the above structure, writing and reading of data having a burst length of 8 bits is made possible while maintaining the random cycle time at 5 clock cycles.

As described above, according to the first embodiment of the present invention, by writing write data into the memory cell array when two write commands are input subsequent to input of the first write command, writing and reading of data having a burst length of 8 bits is made possible while maintaining a short random cycle time.

### Second Embodiment

Next, a fast cycle random access memory according to a second embodiment of the present invention will be explained.

The hardware structure of the fast cycle random access memory according to a second embodiment of the present invention is the same as that of the first embodiment shown in FIG. 6. In the description of the first embodiment, the case wherein the write data has a burst length of 8 bits is explained. In the description of the second embodiment, however, the case wherein the write data has a burst length of 16 bits is explained.

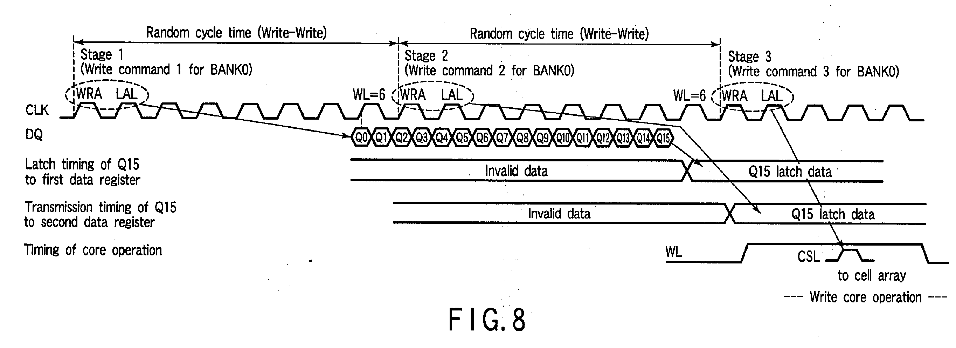

FIG. 8 is a timing chart showing an operation of the fast cycle random access memory according to the second embodiment of the present invention.

FIG. ,8 shows an example wherein the random cycle time is 8 clock cycles (8 cycles of a clock CLK), the write latency (WL) is 6 clock cycles, and the burst length of write data (DQ) is 16 bits (Q0, Q1, Q2, ..., Q15). Similarly, a write command is provided, being expressed with WRA+LAL, in successive two clock cycles.

As shown in FIG. 8, if the first write command, write command 1, is received (stage 1) in order to write write data Q0, Q1, Q2, ..., Q15 into the memory cell array 11 of bank 0, the write data Q0, Q1, Q2, ..., Q15 is temporarily latched in the first data register 21. After that, if the second write command, write command 2, is received (stage 2), the write data Q0 to Q15 latched in the first data register 21 is moved to the second data register 22. Write data Q0 to Q15 input from outside is temporarily latched in the first data register 21. Further, if the third write command, write command 3, is received (stage 3), the write data Q0 to Q15 latched in the second data register 22 is stored in the memory cell MC, the write data Q0 to Q15 latched in the first data register 21 is moved to the second data register 22, and write data Q0 to Q15 input from outside is temporarily latched in the first data register 21.

As in the first embodiment, if a read command is received, it is determined whether the address of the memory cell to be read corresponds to the address corresponding to the data stored in the first data register 21 or the second data register 22. If they correspond, the data stored in the first data register 21 or the second data register 22 is read as read data.

According to the second embodiment of the present invention, by writing write data into the memory cell array when two write commands are input subsequent to input of the first write command, writing and reading of data having a burst length as long as 16 bits is made possible while maintaining a short random cycle time (8 clock cycles).

As the memory cell MC which forms the memory cell array 11 in the first and second embodiments, a dynamic memory cell comprising a capacitor and a transistor can be used.

The first and second embodiments are based on a double data rate method wherein reception (writing) of write data from outside by the write command is performed in synchronization with the leading edge and trailing edge of a clock CLK input from outside. However, a single data rate method may be adopted wherein reception (writing) of write data is performed in synchronization with the leading edge or trailing edge of a clock CLK.

As described above, according to the embodiment of the present invention, it is possible to provide a semiconductor memory which can input/output data having a long burst length, while maintaining a short random cycle time.

Each of the above-described first and second embodiments may be implemented separately, or combined, if necessary. Further, each of the above-described embodiments includes inventions of various stages. It is thus possible to extract the inventions of various states by combining constituent features disclosed in each of the embodiments.

## Claims

1. A semiconductor memory **characterized by** comprising:
a memory cell array (11) having a plurality of memory cells which store data;
a command decoder (14) which decodes a command input from outside; and
an input/output control circuit (20) which controls writing of data into the memory cell and an output of the data to the outside, in accordance with an output of the command decoder (14),
wherein if a write command is input in the command decoder (14), write data received from outside is written in the memory cell when two write commands are input in the command decoder (14) subsequent to the input of the write command.

2. The semiconductor memory according to claim 1, **characterized in that** the write data includes a burst length greater than 4 bits.

3. The semiconductor memory according to claim 2, **characterized in that** the write data has a burst length of 8 bits.

4. The semiconductor memory according to claim 2, **characterized in that** the write data has a burst length of 16 bits.

5. The semiconductor memory according to claim 1, **characterized in that** reception of the write data from outside is performed according to a double data rate method, in which the reception of the write data from outside is synchronized with a leading edge and a trailing edge of a clock signal.

6. The semiconductor memory according to claim 1, **characterized in that** the memory cell which forms the memory cell array (11) is a dynamic memory cell comprising a capacitor and a transistor.

7. The semiconductor memory according to claim 1,
**characterized in that** the memory cell array (11) is a group of memory cells which can not be accessed at the same time, and the semiconductor memory includes a fast cycle random access memory having a short minimum time period (random cycle time) for allowing successive access to the memory cell array (11).

8. A semiconductor memory **characterized by** comprising:
a memory cell array (11) having a plurality of memory cells which store data;
a command decoder (14) which decodes a command input from outside;
a first data register (21) which stores, if a first write command is input in the command decoder (14), write data received from outside;
a second data register (22) to which the write data stored in the first data register (21) is transferred, if a second write command is input in the command decoder (14); and
an input/output control circuit (20) which writes, if a third write command is input in the command decoder (14), the write data stored in the second data register (22) into the memory cell.

9. The semiconductor memory according to claim 8, **characterized in that** the write data includes a burst length greater than 4 bits.

10. The semiconductor memory according to claim 9, **characterized in that** the write data has a burst length of 8 bits.

11. The semiconductor memory according to claim 9, **characterized in that** the write data has a burst length of 16 bits.

12. The semiconductor memory according to claim 8, **characterized in that** reception of the write data from outside is performed according to a double data rate method, in which the reception of the write data from outside is synchronized with a leading edge and a trailing edge of a clock signal.

13. The semiconductor memory according to claim 8, **characterized in that** the memory cell which forms the memory cell array (11) is a dynamic memory cell comprising a capacitor and a transistor.

14. The semiconductor memory according to claim 8, **characterized in that** the memory cell array (11) is a group of memory cells which can not be accessed at the same time, and the semiconductor memory includes a fast cycle random access memory having a short minimum time period (random cycle time) for allowing successive access to the memory cell array.

15. A semiconductor memory **characterized by** comprising:
a memory cell array (11) having a plurality of memory cells which store data;
a command decoder (14) which decodes a command input from outside;
an input/output control circuit (20) which controls writing of data into the memory cell and an output of the data to the outside, in accordance with an output of the command decoder (14);
a first data register (21) which stores write data received from outside;
a first address register (16) which holds an address of the memory cell in which the write data stored in the first data register (21) is to be stored;
a second data register (22) to which the write data stored in the first data register (21) is transferred; and
a second address register (17) which holds an address of the memory cell in which the write data stored in the second data register (22) is to be stored,
wherein if the first write command is input in the command decoder (14), first write data received from outside is stored in the first data register (21),
if the second write command is input in the command decoder (14), the first write data stored in the first data register (21) is transferred to the second data register (22), and second write data received from outside is stored in the first data register (21), and
if a third write command is input in the command decoder (14), the first write data stored in the second data register (22) is written in the memory cell, the second write data stored in the first data register (21) is transferred to the second data register (22), and third write data received from outside is stored in the first data register (21).

16. The semiconductor memory according to claim 15, **characterized by** further comprising:
a third address register (15) which holds, if a read command is input in the command decoder (14), an address of the memory cell to be read;
a first address comparison circuit (18) which compares the address held in the first address register (16) with the address held in the third address register (15), and outputs a comparison result to the input/output control circuit (20); and
a second address comparison circuit (19) which compares the address held in the second address register (17) with the address held in the third address register (15), and outputs a comparison result to the input/output control circuit (20),
wherein if the comparison result output from the first address comparison circuit (18) is a signal indicating that the two addresses correspond to each other, the input/output control circuit (20) outputs the write data stored in the first data register (21) to the outside as read data, and
if the comparison result output from the second address comparison circuit (19) is a signal indicating that the two addresses correspond to each other, the input/output control circuit (20) outputs the write data stored in the second data register (22) to the outside as read data.

17. The semiconductor memory according to claim 15, **characterized in that** the first, second and third write data each includes a burst length greater than 4 bits.

18. The semiconductor memory according to claim 17, **characterized in that** the first, second and third write data each has a burst length of 8 bits.

19. The semiconductor memory according to claim 17, **characterized in that** the first, second and third write data each has a burst length of 16 bits.

20. The semiconductor memory according to claim 15, **characterized in that** reception of the first, second and third write data from outside is performed according to a double data rate method, in which the reception of the first, second, and third write data from outside is synchronized with a leading edge and a trailing edge of a clock signal.

21. The semiconductor memory according to claim 15, **characterized in that** the memory cell which forms the memory cell array (11) is a dynamic memory cell comprising a capacitor and a transistor.

22. The semiconductor memory according to claim 15, **characterized in that** the memory cell array (11) is a group of memory cells which can not be accessed at the same time, and the semiconductor memory includes a fast cycle random access memory having a short minimum time period (random cycle time) for allowing successive access to the memory cell array.

23. A fast cycle random access memory
**characterized by** comprising:
a memory cell array (11) having a plurality of memory cells which store data;
a command decoder (14) which decodes a command input from outside; and
an input/output control circuit (20) which controls writing of data into the memory cell and an output of the data to the outside, in accordance with an output of the command decoder (14),
wherein if a write command is input in the command decoder (14), write data received from outside is written in the memory cell when two write commands are input in the command decoder (14) subsequent to the input of the write command.
